(19) **Europäisches Patentamt**
**European Patent Office**
**Office européen des brevets**

(11) **EP 1 511 170 B1**

(12) **EUROPEAN PATENT SPECIFICATION**

(45) Date of publication and mention
of the grant of the patent:
**13.10.2010 Bulletin 2010/41**

(51) Int Cl.:
*H03F 1/08* (2006.01)     *H03F 3/45* (2006.01)
*H03F 1/26* (2006.01)     *H03F 1/48* (2006.01)

(21) Application number: **03425561.2**

(22) Date of filing: **28.08.2003**

(54) **AC low noise differential amplifier with reduced low corner frequency**

Rauscharmer Wechselstromdifferenzverstärker mit reduzierter niedriger Grenzfrequenz

Amplificateur différentiel de courant alternatif à faible bruit avec fréquence de coude bas réduite

(84) Designated Contracting States:
**DE FR GB IT**

(43) Date of publication of application:
**02.03.2005 Bulletin 2005/09**

(73) Proprietor: **STMicroelectronics Srl**
**20041 Agrate Brianza (MB) (IT)**

(72) Inventor: **Bollati, Giacomino**
**29015 Castel San Giovanni (IT)**

(74) Representative: **Pellegri, Alberto et al**
**Società Italiana Brevetti S.p.A.**
**Via Avegno, 6**
**21100 Varese (IT)**

(56) References cited:
**GB-A- 2 320 987**     **US-A- 5 510 738**
**US-A1- 2002 003 441**     **US-B1- 6 262 628**
**US-B1- 6 359 503**

**Description**

FIELD OF THE INVENTION

The present invention relates to AC amplifiers and more in particular to an AC low noise differential amplifier with reduced low-comer frequency (LCF).

BACKGROUND OF THE INVENTION

In many applications it is necessary to amplify an AC signal superimposed to a relatively large DC component. In these cases, an AC amplifier fed with the input signal through decoupling capacitors is commonly used. This in particular is the case in signal channels for recording data to hard disk drives (HDD).

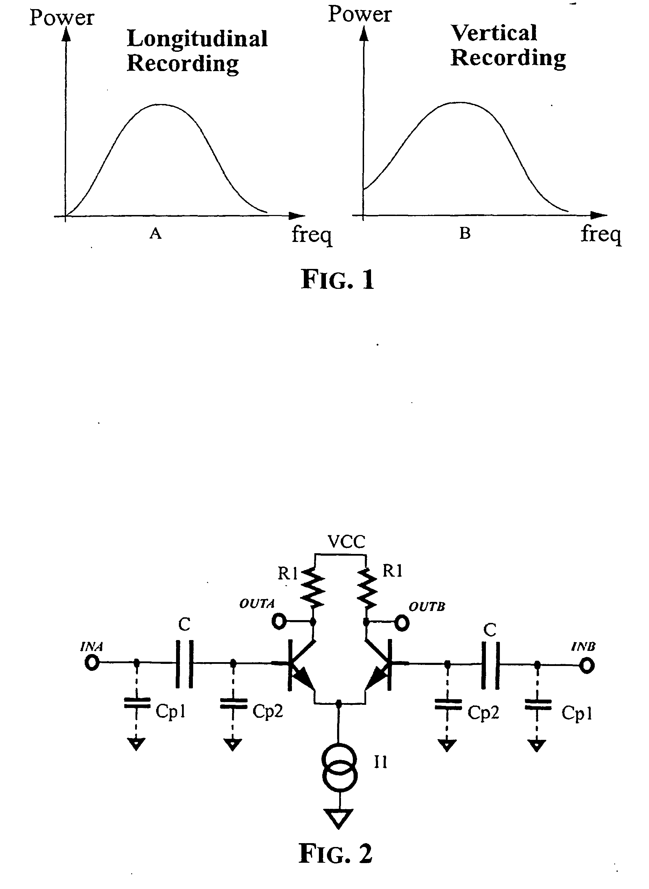

Two modes of recording data on a HDD are the so-called "longitudinal recording" and the "vertical recording". As far as the AC amplifier is concerned, the main difference between these two techniques consists in that a typical spectrum of an AC signal to be amplified, when using the "longitudinal recording" technique, differs noticeably from the spectrum of a corresponding signal, when using the "vertical recording" technique. As may be noticed by comparing the two diagrams of Figure 1, signals used for recording data on a HDD using the "vertical recording" technique have a non negligible power content at very low frequencies.

Therefore, the pass-band of AC amplifiers optimized for "vertical recording" must. extend to relatively low frequencies, in other words they must have a reduced low comer frequency (LCF).

Typically, an AC amplifier is composed of a differential amplifier as that of Figure 2. A differential input signal is fed to the inputs INA and INB through respective decoupling input capacitors C. The architecture of this amplifier is very simple, but a sufficiently reduced LCF may be achieved only by using relatively large decoupling capacitors C.

Unfortunately, in silicon integrated circuits, when the size of the decoupling capacitors C is enlarged, the augmented parasitic capacitances CP1 and CP2 between the plates of the integrated capacitors and the silicon substrate on which the amplifier is realized significantly increase the input capacitance of the amplifier.

In order to keep parasitic capacitances smaller than a maximum acceptable value, these relatively large DC-decoupling capacitors must eventually be fabricated in a metal-dielectric-metal form which means burdening the fabrication process with additional steps and fabrication masks.

The US patent No. 6,262,628 discloses a differential amplifier that occupies a reduced silicon area because it does not require two coupling capacitors.

GB 2 320 987, upon which the preamble of claim 1 is drafted, discloses a differential amplifier with a DC offset cancellation circuit.

OBJECT AND SUMMARY OF THE INVENTION

This drawback of the existing art is overcome by the novel low noise AC amplifier of the present invention. It has been found possible to effectively decouple the DC component of the input signal by employing for this purpose decoupling capacitors in a position such that parasitic capacitances associated to the decoupling capacitors do not degrade the input capacitance of the stage.

As a consequence, these decoupling capacitors may remain fabricable in a low cost manner, such as in the form of so-called poly-nwell capacitors, that may be integrated in a common fabrication process without requiring dedicated (additional) masks.

It has been found that it is not necessary to employ decoupling capacitors connected directly to the respective input nodes for filtering the DC component of the differential input.

An effective filtering of the DC component in an AC amplifier is obtained by connecting decoupling capacitors between ground and input nodes of the two transconductance stages, which are AC grounded, thus making negligible the effect of parasitic capacitances on the input impedance of the amplifier.

More precisely the object of this invention is an AC low noise differential amplifier defined in the annexed claims.

BRIEF DESCRIPTION OF THE DRAWINGS

The different aspects and advantages of the invention will become more evident through a detailed description referring to the attached drawings, wherein:

> **Figures 1a and 1b** show sample power-frequency spectra of signals used in the so-called longitudinal recording and vertical recording of HDDs, respectively;
> **Figure 2** depicts an AC amplifier;
> **Figure 3** shows an AC differential amplifier;
> **Figure 4** shows a detailed amplifier;
> **Figure 5** shows another amplifier;
> **Figure 6** shows an equivalent noise circuit to the amplifier of Figure 2;
> **Figure 7** shows an equivalent noise circuit to the amplifier of Figures 4 or 5;
> **Figure 8** shows a simplified noise circuit equivalent to that of Figure 7;
> **Figure 9** shows the preferred embodiment of the amplifier of the invention;
> **Figure 10** shows a high frequency equivalent circuit to that of Figure 9;
> **Figure 11** shows an equivalent noise circuit to the amplifier of Figure 9;
> **Figure 12** shows a simplified noise circuit equivalent to that of Figure 11.

DETAILED DESCRIPTION

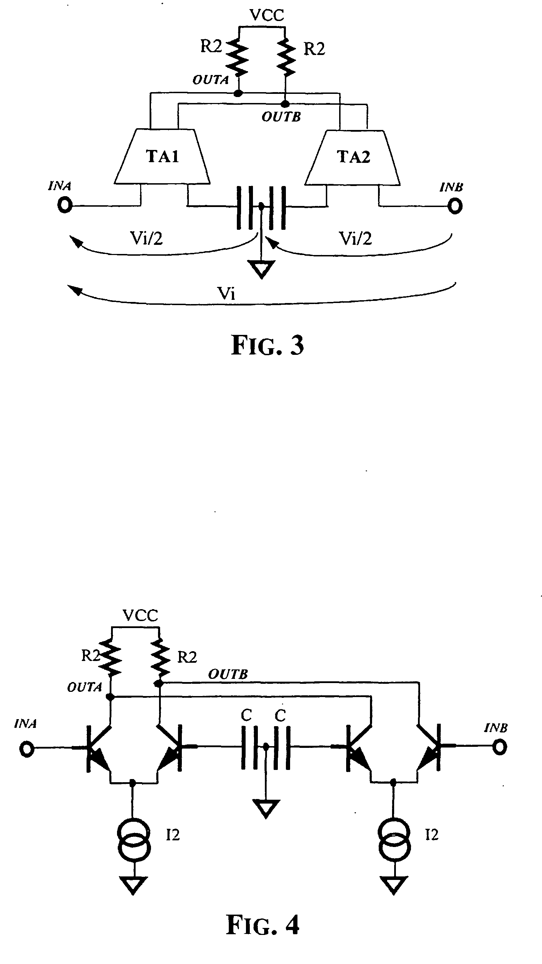

A basic architecture of an amplifier is depicted in Figure 3 and a sample thereof using bipolar junction transistors (BJT) is depicted in Figure 4, however the same considerations that will be made substantially hold *mutatis mutandis* also if the amplifier is realized with field effect transistors (MOSFET) instead ofBJTs.

The AC differential amplifier is composed of two transconductance stages TA1 and TA2, two respective inputs of which are connected in series through capacitive means, composed for example of a series of two capacitors, the intermediate node of which is grounded. Corresponding output nodes of the transconductance stages are connected in common for summing the output currents on shared load resistors R.

The input signal applied to the input nodes INA and INB is filtered from its DC component even if there are no decoupling capacitors connected to (upstream of) the input nodes INA, INB of the amplifier.

In fact, the effect of the two identical capacitors C is to make the DC voltages on the control nodes of the transistors of each differential pair equal to each other, and this common mode voltage is rejected by the differential pairs.

This architecture solves the problems caused by parasitic capacitances because the decoupling capacitor are not connected to the input nodes INA and INB for filtering the input signal from its DC component, but they are both connected between ground and a control node of a transistor, which is an AC grounded node, thus minimizing undesired effects of the parasitic capacitances on the input impedance of the amplifier.

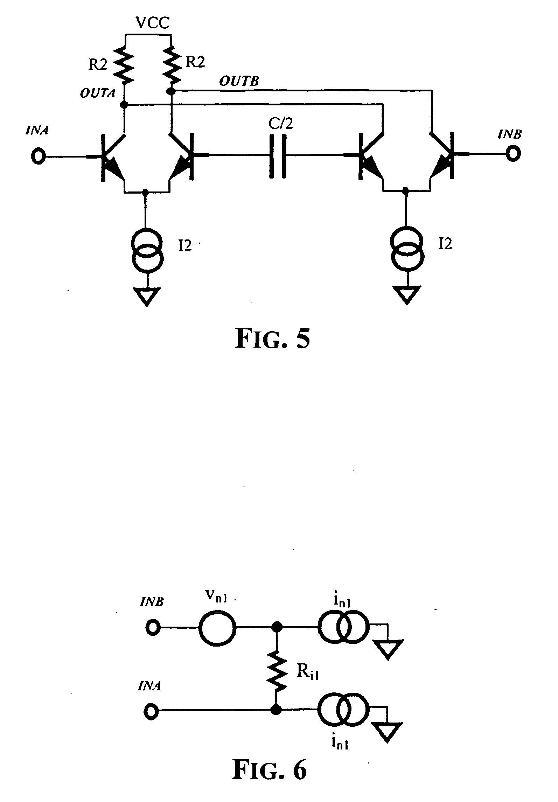

It is worth noticing that the circuit scheme of Figure 5 is substantially equivalent to that of Figure 4. In fact, at working frequencies comprised in the pass band, the capacitor C/2 connected between the two control nodes is short-circuited, because for that working frequencies these control nodes are practically grounded.

Being GM the transconductance of each stage, the transconductance of the amplifier of Figures 4 and 5 is GM because only one half of the input signal Vi is applied to each differential pair. Therefore, the objective of overcoming the problems due to parasitic capacitances is achieved at the cost of using two transconductance stages of gain GM.

An attendant drawback of the circuit architectures of Figure 4 and 5 is in that the noise is higher than the noise of the stage of Figure 2.

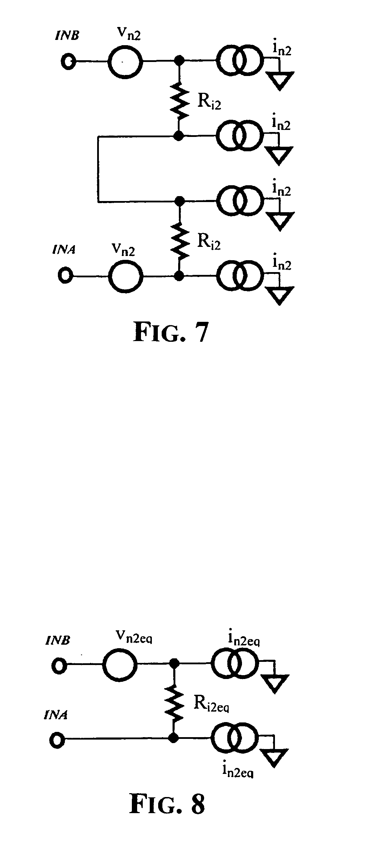

The equivalent noise circuit of the amplifier of Figure 2 is depicted in Figure 6 and the noise circuit of the amplifier of Figures 4 and 5 is depicted in Figure 7.

Figure 8 depicts a simplified noise circuit equivalent to that of Figure 7 for comparing the noise figures of the amplifier of Figures 4 and 5 with the amplifier of Figure 2.

The voltage generator $v_{n1}$ is a voltage noise source the power spectral density $v_{n1}^2$ of which is

$$v_{n1}^2 = 8 \cdot K \cdot T \cdot \left( R_{BB1} + \frac{V_T}{I_1} \right)$$

wherein K is the Boltzmann's constant, $V_T$ is the thermal voltage of the amplifier and $R_{BB1}$ is the base-access physical resistance of the transistors pair of the amplifier of Figure 2.

The resistance $R_{i1}$ is the noise impedance of the amplifier.

The power spectral density of the noise equivalent current generator $i_{n1}$ is

$$i_{n1}^2 = 2 \cdot q \cdot \frac{I_1}{2} \cdot \left( \frac{1}{\beta} + \frac{1}{\beta(\omega)^2} \right)$$

wherein q is the electron charge, $\beta$ is the DC common-emitter forward short-circuit current gain and $\beta(\omega)$ is its value at frequency $\omega$.

Similarly, the power spectral densities of the generators $v_{n2}$ and $i_{n2}$ in Figure 7 are defined by the following formulas:

$$v_{n2}^2 = 8 \cdot K \cdot T \cdot \left( R_{BB2} + \frac{V_T}{I_2} \right)$$

$$i_{n2}^2 = 2 \cdot q \cdot \frac{I_2}{2} \cdot \left( \frac{1}{\beta} + \frac{1}{\beta(\omega)^2} \right)$$

wherein $R_{BB2}$ is the base-access physical resistance of each differential pair of transistors of Figures 4 and 5.

The resistance $R_{i2}$ is the noiseless input impedance of each differential pair.

The power spectral densities of the voltage and current generators $v_{n2eq}$ and $i_{n2eq}$, respectively, of the noise equivalent circuit of Figure 8 are defined by the following formulas:

$$v_{n2eq}^2 = 2 \cdot v_{n2}^2 \qquad ; \qquad i_{n2eq}^2 = i_{n2}^2$$

and the resistance $R_{i2eq}$ is the noiseless input impedance of the whole amplifier and is given by the following formula:

$$R_{i2eq} = 2 \cdot R_{i2}$$

By comparing the noise equivalent circuits of Figure 6 and 8 it may be said that the noise figure of the amplifier of Figures 4 and 5 is higher than the one of the amplifier of Figure 2.

Indeed, the amplifier of Figures 4 and 5 has the same input-referred voltage noise than the amplifier of Figure 2 when

$$R_{BB2} = R_{BB1}/2 \qquad ; \qquad I2 = 2*I1$$

but at the same time the power spectral density $i^2_{n2eq}$ of the input-referred current noise is twice that of the amplifier of Figure 2

$$i^2_{n2eq} = 2 \cdot i^2_{n1}$$

By contrast, when

$$I2 = I1$$

the amplifier of Figure 2 and the amplifier of of Figures 4 and 5 have the same input-referred current noise, but the power spectral density of the input-referred voltage noise of the amplifier of the invention is higher than the one of the stage of Figure 2. In particular, if

$$R_{BB2} = R_{BB1}$$

then the power spectral density of the input-referred voltage noise of the amplifier of the invention is twice that of the stage of Figure 2:

$$v^2_{n2eq} = 2 \cdot v^2_{n1}$$

Generally speaking, the noise figures of the amplifiers of Figures 4 and 5 are worse than that of the amplifier of Figure 2.

The values of the current I2 and of the resistance $R_{BB2}$ must be chosen not only according to noise considerations but also considering that increasing the bias current I2 implies increasing the base-emitter capacitance of the transistor pair, and that for reducing the resistance $R_{BB2}$ it is necessary to increase the size of the transistors, thus increasing also their base-collector capacitances affecting the input capacitance of the amplifier.

Moreover, in order to optimize noise figures of the amplifier of the invention it is necessary to remember that (from the noise theory of amplifiers) the best noise figure is achieved when the noise impedance of the amplifier matches the impedance of the external generator of the signal to be amplified. Therefore, when the generator of the input signal has a relatively large impedance, it is desirable to reduce the input-referred current noise, and the other way around when the noise impedance of the external generator is relatively small.

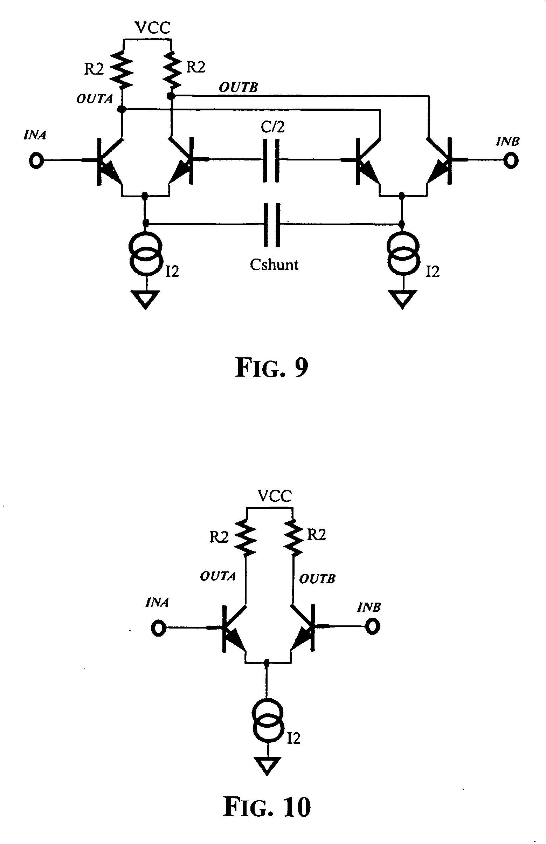

This attendant drawback of a larger noise figure of the amplifier may be eliminated by a relatively minor increase of circuital complexity. According to a preferred embodiment of this invention, the noise performances of the amplifier of Figures 4 or 5 at high frequencies are improved by connecting the common current nodes of the transistors of the two differential pairs by a shunt capacitor CSHUNT, as shown in Figure 9.

At high frequencies, the shunt capacitor behaves as a short circuit and thus the voltage of the common current node of the transistors of the two differential pairs are in practice at the same voltage. Therefore, in the pass band the circuit of Figure 9 is equivalent to that the circuit depicted in Figure 10, which is in practice identical to that of Figure 2. Obviously, the noise figures of the amplifier of Figure 9 must be the same of that of the circuit of Figure 2, as confirmed by the following rigorous analysis.

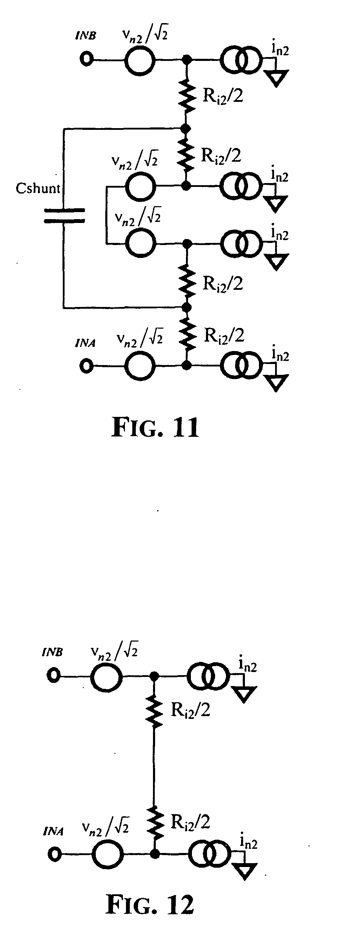

The noise equivalent circuit of the preferred embodiment of the invention depicted in Figure 9 is shown in Figure 11. Simplifying this last noise circuit, one obtains the circuit of Figure 12. The total power spectral density of the input-referred voltage noise of the amplifier of Figure 12 is

$$\left(\frac{v_{n2}}{\sqrt{2}}\right)^2 + \left(\frac{v_{n2}}{\sqrt{2}}\right)^2 = v^2_{n2}$$

which is half the power spectral density of the input-referred voltage noise of the amplifiers of Figures 4 and 5.

A big shunt capacitor reduce the noise in a wide frequency range but, on the other hand, it increases the input capacitance of the amplifier. In fact, without the shunt capacitor, the single-ended input capacitance due to the base-emitter capacitance $C\pi$ of the input transis-

tors is halved Cπ/2, while at frequencies for which the capacitor CSHUNT behaves as a short-circuit the single-ended input capacitance due to the base-emitter capacitance Cπ of the transistors is Cπ.

## Claims

1. An AC low noise differential amplifier, comprising a pair of identical differential transconductance stages (TA1, TA2), the corresponding output nodes of which (OUTA, OUTB) are coupled to a supply line (VCC), an input node of one transconductance stage being coupled through capacitive means to an input node of the other transconductance stage, the other input nodes (INA, INB) of the two transconductance stages constituting the input terminals of the amplifier, said corresponding output nodes (OUTA, OUTB) of the transconductance stages being connected in common and constituting a pair of output nodes of the AC low noise differential amplifier, and being connected through respective load resistors (R2) to the supply line (VCC), wherein each of said identical differential transconductance stages is composed of a differential pair of transistors, which are configured to be biased by a current generator (I2) through their common emitter or source node, the base or gate nodes of which constitute the input nodes of the transconductance stage and the collector or drain nodes (OUTA, OUTB) constitute the output nodes of the transconductance stage, **characterised in that** said common emitter or source nodes of the two differential pairs of transistors being coupled together by a shunt capacitor (CSHUNT).

2. The AC low noise differential amplifier of claim 1, wherein said capacitive means are composed of two identical capacitors (C) in series, the intermediate node of which is grounded.

3. The AC low noise differential amplifier of claim 1, wherein said capacitive means are in the form of a single capacitor (C/2).

## Patentansprüche

1. Rauscharmer Wechselstromdifferenzverstärker, der ein Paar identischer Differenztranskonduktanzstufen (TA1, TA2) aufweist, deren entsprechende Ausgangsknoten (OUTA, OUTB) mit einer Versorgungsleitung (VCC) gekoppelt sind, wobei ein Eingangsknoten einer Transkonduktanzstufe durch kapazitive Mittel mit einem Eingangsknoten der anderen Transkonduktanzstufe gekoppelt ist, wobei die anderen Eingangsknoten (INA, INB) der beiden Transkonduktanzstufen die Eingangsanschlüsse des Verstärkers bilden, wobei die entsprechenden Ausgangsknoten (OUTA, OUTB) der Transkonduktanzstufen gemeinsam angeschlossen sind und ein Paar Ausgangsknoten des rauscharmen Wechselstromdifferenzverstärkers bilden, und durch jeweilige Lastwiderstände (R2) mit der Versorgungsleitung (VCC) verbunden sind, wobei jede der identischen Differenztranskonduktanzstufen aus einem Paar Differenztransistoren besteht, die konfiguriert sind, durch einen Stromgenerator (I2) durch ihren gemeinsamen Emitter- oder Source-Knoten vorgespannt zu werden, deren Basis- oder Gate-Knoten die Eingangsknoten der Transkonduktanzstufe bilden und die Kollektor- oder Drain-Knoten (OUTA, OUTB) die Ausgangsknoten der Transkonduktanzstufe bilden, **dadurch gekennzeichnet, daß** die gemeinsamen Emitter- oder Source-Knoten der beiden Differenztransistorpaare durch einen Nebenschlußkondensator (CSHUNT) miteinander gekoppelt sind.

2. Rauscharmer Wechselstromdifferenzverstärker nach Anspruch 1, wobei die kapazitiven Mittel aus zwei identischen Kondensatoren (C) in Reihe bestehen, deren Zwischenknoten geerdet ist.

3. Rauscharmer Wechselstromdifferenzverstärker nach Anspruch 1, wobei die kapazitiven Mittel in der Form eines einzelnen Kondensators (C/2) vorliegen.

## Revendications

1. Amplificateur différentiel alternatif à faible bruit comprenant deux étages de transconductance différentiels identiques (TA1, TA2), dont les noeuds de sortie correspondant (OUTA, OUTB) sont couplés à une ligne d'alimentation (VCC), un noeud d'entrée d'un étage de transconductance étant couplé par des moyens capacitifs à un noeud d'entrée de l'autre étage de transconductance, les autres noeuds d'entrée (INA, INB) des deux étages de transconductance constituant les bornes d'entrée de l'amplificateur, les noeuds de sortie correspondant (OUTA, OUTB) des étages de transconductance étant connectés ensemble et constituant deux noeuds de sortie de l'amplificateur différentiel alternatif à faible bruit et étant connectés par l'intermédiaire de résistances de charge respectives (R2) à la ligne d'alimentation (VCC), dans lequel :

chacun des étages de transconductance différentiels identiques est constitué d'une paire différentielle de transistors qui sont agencés pour être polarisés par un générateur de courant (I2) par leur noeud commun d'émetteur ou de source, les noeuds de base ou de grille constituant les noeuds d'entrée de l'étage de transconductance et les noeuds de collecteur ou de drain (OUTA, OUTB) constituant les noeuds de sortie de l'étage de transconductance,
**caractérisé en ce que** les noeuds commun d'émetteur ou de source des deux paires différentielles de transistors sont couplés ensemble par un condensateur shunt (CSHUNT).

2. Amplificateur différentiel alternatif à faible bruit selon la revendication 1, dans lequel les moyens capacitifs sont constitués de deux condensateurs (C) identiques en série, dont le noeud intermédiaire est mis à la masse.

3. Amplificateur différentiel alternatif à faible bruit selon la revendication 1, dans lequel les moyens capacitifs sont constitués d'un condensateur unique (C/2).

**FIG. 1**

**FIG. 2**

FIG. 3

FIG. 4

FIG. 5

FIG. 6

**FIG. 7**

**FIG. 8**

FIG. 9

FIG. 10

**FIG. 11**

**FIG. 12**

EP 1 511 170 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6262628 B

- GB 2320987 A